# EUROPEAN PATENT SPECIFICATION

(11) **EP 1 928 222 B1**
(45) Date of publication and mention of the grant of the patent: **28.09.2011**
(21) Application number: 06781961.5
(22) Date of filing: 28.07.2006
(51) Int. Cl.: H05K 13/04, H01L 25/00, H05K 3/34

(54) **PACKAGING METHOD OF ELECTRONIC COMPONENT MODULE AND ELECTRONIC COMPONENT MODULE**
VERKAPSELUNGSVERFAHREN FÜR EIN ELEKTRONISCHES KOMPONENTENMODUL UND ELEKTRONISCHES KOMPONENTENMODUL
PROCÉDÉ D'EMBALLAGE DE MODULE DE COMPOSANT ÉLECTRONIQUE ET MODULE DE COMPOSANT ÉLECTRONIQUE

(30) Priority: 22.09.2005 JP 2005276572
(43) Date of publication of application: 04.06.2008
(73) Proprietor: MURATA MANUFACTURING CO., LTD., Nagaokakyo-shi, Kyoto 617-8555 (JP)
(72) Inventor: KOYAMA, Kunihiro, Nagaokakyo-shi Kyoto 617-8555 (JP); YAMAMOTO, Muneyoshi, Nagaokakyo-shi Kyoto 617-8555 (JP); UEJIMA, Takanori, Nagaokakyo-shi Kyoto 617-8555 (JP); NAKAGAWA, Dai, Nagaokakyo-shi Kyoto 617-8555 (JP); KIMURA, Masaki, Nagaokakyo-shi Kyoto 617-8555 (JP)
(74) Representative: Schoppe, Fritz
(86) International application number: PCT/JP2006/315051
(87) International publication number: WO 2007/034626

(56) References cited:
- JP-A- 2000 077 604
- JP-A- 2002 261 581
- JP-A- 2003 124 701
- US-A- 3 625 763
- US-A- 6 054 008
- US-A1- 2001 023 983
- US-B1- 6 629 363

## Description

### Technical Field

The present invention relates to a method for mounting an electronic-component module, a method for manufacturing an electronic apparatus using the method for mounting an electronic-component module, and an electronic-component module. Specifically, the present invention relates to a method for mounting an electronic-component module which is mounted in a process in which an adsorption head holds the electronic-component module by adsorption while the module is being placed on a target board, a method for manufacturing an electronic apparatus using the method for mounting an electronic-component module, and an electronic-component module applicable to these methods.

### Background Art

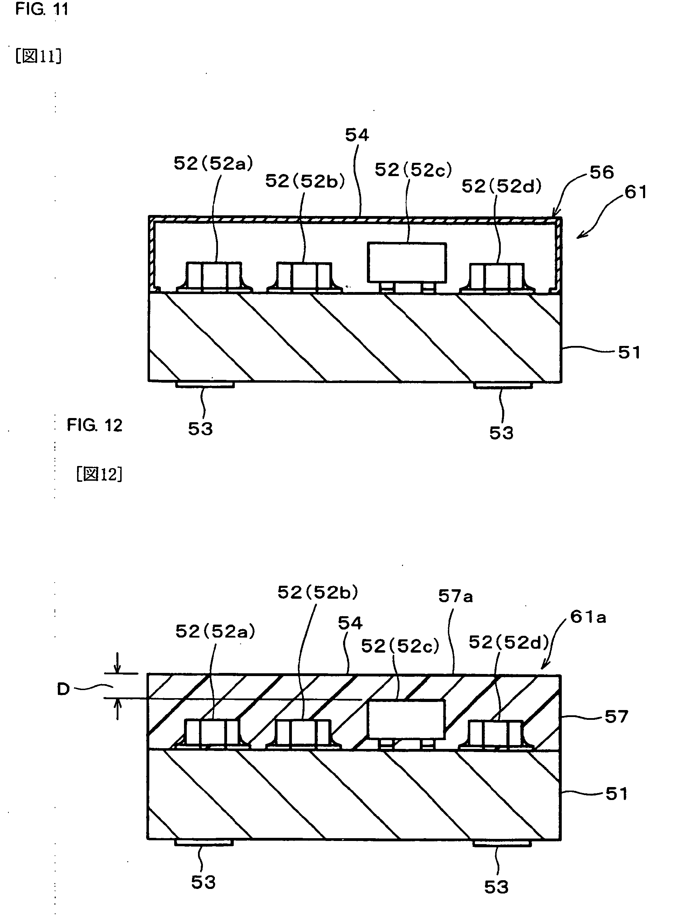

Fig. 11 is a view showing a structure of a conventional electronic-component module. As shown in Fig. 11, an electronic-component module 61 has a structure composed of an electronic-component base plate 51, which is made of a ceramic plate or the like, having terminal electrodes 53 on a lower face thereof and surface-mount devices (SMDs) 52 (for example, capacitor 52a, resistor 52b, transistor 52c, and coil 52d) on an upper face thereof and a metal case 56 having a flat top face covering the upper face of the electronic-component base plate 51 having the surface-mount devices 52 thereon. Note that various electronic-component modules having a similar structure to the electronic-component module 61 shown in Fig. 11, are provided (refer to Patent Document 1), and the structure shown in Fig. 11 is well known.

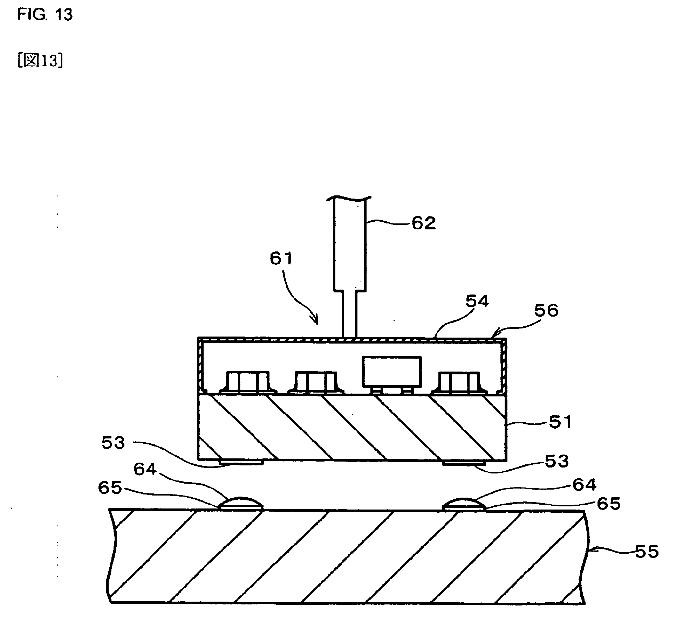

Here, the metal case 56, which is used in the above-mentioned electronic-component module 61, has two main functions as follows, that is,
(a) providing an electromagnetic shield that reduces an electromagnetic influence of the surface-mount devices 52 on other electronic apparatuses and an electromagnetic influence of other electronic apparatuses on the surface-mount devices 52; and
(b) providing an adsorption face 54 (shown in Fig. 13) that is used in an operation for adsorbing the electronic-component module 61 with an adsorption head 62 (shown in Fig. 13), which is prepared for mounting components. That is, the flat top face of the metal case 56 serves as the adsorption face 54.

Furthermore, as shown in Fig. 12, an electronic-component module 61a having a molded resin 57, which is used instead of the metal case 56 to seal the surface-mount devices 52, is known. In such a case, a top face 57a of the molded resin 57 serves as the adsorption face 54. Note that, in Fig. 12, the same reference numerals as used in Fig. 11 denote the same portions as or portions corresponding to those shown in Fig. 11.

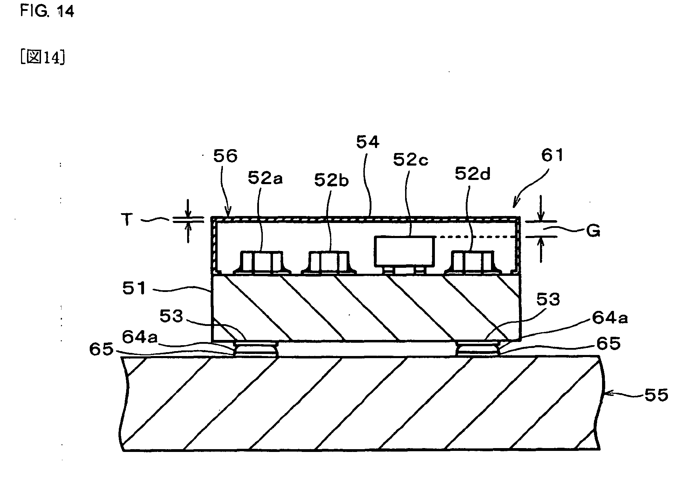

When the above-mentioned electronic-component module 61 (shown in Fig. 11) is mounted on a motherboard 55, which is a target board, generally, mounting is performed according to the following procedure (refer to Figs. 13 and 14).
(1) As shown in Fig. 13, a top face, which serves as an adsorption face 54, of a metal case 56 of the electronic-component module 61 is adsorbed with an adsorption head 62.
(2) The electronic-component module 61 is held with the adsorption head 62 and conveyed to a place over the target board, that is, the motherboard 55. Then the electronic-component module 61 is placed on predetermined land electrodes 65 on which soldering paste 64 is printed in advance (shown in Fig. 14).
(3) Then, the motherboard 55 is carried into a reflow oven and heated under predetermined conditions so as to melt solder in the soldering paste 64. Then, the electronic-component module 61 is fixed on the land electrodes 65 on the motherboard 55 with solder 64a.

Recently, however, with improvements in the performances of surface-mount devices and shield performances of electronic apparatuses, the above-mentioned function (a) among the functions of the metal case has not been necessarily required.

Furthermore, recently, electronic apparatuses such as portable phones have been miniaturized, and according to this, reduction in the height of an electronic-component module, which is to be used in such electronic apparatuses, has been increasingly required.

However, when a conventional electronic-component module is mounted, as shown in Fig. 14, since a gap G between a lower face of a metal case 56 and upper ends of the surface-mount devices including a capacitor 52a, resistor 52b, transistor 52c, and coil 52d is needed, and further, room to accommodate the thickness T of the metal case 56 is also needed, there is a problem that the resulting product is higher than the surface-mount devices by a distance including the gap G and the thickness T.

Furthermore, since a gap in the horizontal direction between the metal case 56 and the surface-mount devices including a capacitor 52a, resistor 52b, transistor 52c, and coil 52d is also needed, a mountable area in the electronic-component base plate 51 for the surface-mount devices is decreased. This prevents the miniaturization of the resulting product.

Therefore, since there are the above-mentioned gap G and the thickness T of the metal case 56, even if a thinner electronic-component base plate 51 and smaller surface-mount devices including a capacitor 52a, resistor 52b, transistor 52c, and coil 52d alone are provided, it is difficult to sufficiently lower the height of the electronic-component module.

Note that, in the case that an electronic-component module 61a shown in Fig. 12 is used, which has surface-mount devices sealed with a molded resin 57, a mountable area (plane area) for surface-mount devices can become large compared with the case when the metal case is used. However, since a top face 57a of the molded resin 57 is higher than upper ends of the surface-mount devices, there is a problem that the resulting product is higher than the surface-mount devices by the distance D, i.e., the distance between the top face 57a of the molded resin 57 and the upper ends of the surface-mount devices.
Patent Document 1: Japanese Unexamined Patent Application Publication No. 5-190380

US 6054008 A discloses a process and apparatus for picking up and moving a microelectronic package during card assembly operations. A temporary lid having a top surface and a bottom surface attaches to at least one microchip on a substrate via a double-sided adhesive. The top surface of the lid provides a clean, smooth, flat surface to which a vacuum probe may be attached. After completion of the steps where vacuum probe movement is required, the lid and adhesive may be removed from the at least one microchip by pulling them both off together. No residue is left on the microchips.

US 2001/023983 A1 discloses a semiconductor device capable of preventing the likely occurrence of cracking of a ceramic substrate, and the consequential disconnection of internal layer wiring, due to the thermal changes suffered when the semiconductor device is mounted on external wiring boards different in thermal expansion coefficient. A semiconductor device comprises a ceramic substrate provided with the first and second principal planes. A wiring pattern is formed on said first principal plane and has mounted semiconductor components. An external electrode portion is formed on said second principal plane and connected to an external circuit. Internal layer wiring is formed inside said ceramic substrate to electrically connect said wiring pattern and said external electrode portion via through-hole wiring. Semiconductor components are connected to said wiring pattern, and a resin layer for covering said first principal plane and said semiconductor components is provided.

The present invention solves the above-mentioned problems and the object thereof is to provide a method for mounting an electronic-component module in which an adsorption head can adsorb and hold the electronic-component module, the electronic-component module can be efficiently mounted on a target board, and the height of the electronic-component module mounted on the target board can be sufficiently lowered and a method for manufacturing an electronic apparatus involving the above-mentioned method, and an electronic-component module that can sufficiently lower the height of the electronic-component module mounted on the target board.

In order to solve the above-mentioned problems, the present invention provides a method according to claim 1 and a module according to claim 7.

Developments of the invention are defined in the dependent claims.

### Advantages

According to the method for mounting the electronic-component module of the present invention, at a side of a face of the electronic-component module having surface-mount devices placed thereon, which is composed of an electronic-component base plate and surface-mount devices mounted on the electronic-component base plate, an adsorption face member is provided in a manner in which an adsorption face, which is provided for being adsorbed with an adsorption head during adsorption, is formed at a position being higher than a position of upper ends of the surface-mount devices. Then the adsorption face of the adsorption face member is adsorbed with the adsorption head and the electronic-component module is held so as to be placed on a target board. Then, in order to prevent the situation in which the upper end of the adsorption face member is higher than the upper ends of the surface-mount devices mounted on the electronic-component base plate, the adsorption face member is removed or reshaped. Therefore, when the electronic-component module is being mounted, by using the adsorption head which adsorbs the adsorption face of the adsorption face member, the electronic-component module can be held with ease and certainty and can be efficiently mounted with an automatic mounter or the like. Furthermore, after mounting, the situation in which the upper end of the adsorption face member is higher than the upper ends of the surface-mount devices mounted on the electronic-component base plate, is prevented with certainty, so that the maximum reduction of a height of a resulting product can be achieved.

Note that, after mounting the electronic-component module on the target board, if the height of the adsorption face is substantially equal to the height of the upper end of the tallest surface-mount device, there is no need to lower the upper end of the adsorption face member, i.e., the position of the adsorption face. In such a case, a treatment for removing or reshaping the adsorption face member may not be limited.

Examples of the adsorption face member include organic material members such as resins that are vaporized, liquefied, softened, or reduced in volume by heating.

As an example of a material that can be vaporized by heating, naphthalene is given.

Naphthalene is a material having sublimation properties, which changes its phase from a solid to a gas without passing through a liquid phase, and is preferably used as the adsorption face member of the present invention.

Note that, as an example of a material with sublimation properties, paradichlorobenzene is given.

Here, as an example of the adsorption face member of the present invention, a material which changes its phase to a gas passing through a liquid phase can be used as well as the material with sublimation properties.

Furthermore, as the adsorption face member of the present invention, a resin that is reducible (shrinkable) in volume by heating, for example, a resin shrinkable by polymerization or a resin containing gaseous babbles that are released when heated resulting in the reduction of the volume thereof can be used.

Furthermore, as a material that cannot be removed or does not shrink, a heat-liquefiable (fusible) or heat-softenable material such as a synthetic resin, a natural resin, or a glass composition can be used. That is, a material, which is fluidized through fusing or softening by heating and can prevent the situation in which the upper end of the adsorption face member is higher than the upper ends of surface-mount devices mounted on electronic-component base plate, can be used.

Furthermore, if the adsorption face member is an organic material, as a step of removing or reshaping the organic material, by using at least one method selected from among methods that involve (a) eliminating the organic material member by heating, (b) reducing a volume of the organic material member by heating, and (c) reshaping the organic material member by heating without changing the volume thereof, the situation, in which the upper end of the adsorption face member is higher than the upper ends of the surface-mount devices mounted on the electronic-component base plate, can be effectively prevented. This makes the present invention effective.

Note that, as an example of the above-mentioned method that involves (a) eliminating the organic material member by heating, a method that involves volatilizing or sublimating, i.e., vaporizing, the whole part of the organic material member is given. However, other methods that involve including dissolving and removing a whole part of organic material member with a solvent can be used.

Note that, as the above-mentioned method that involves (b) reducing a volume of the organic material member by heating, examples include a method that involves volatilizing or sublimating a part of the organic material member and a method that involves a resin which reduces the volume thereof by heating. There are, however, other methods, for example, a method that involves dissolving and removing a part of the organic material member with a solvent, can be used. Here, in the present invention, the method that involves reducing the volume of an organic material member by heating is an aspect of the concept of "reshaping of an adsorption face member" of the present invention.

Furthermore, as an example of the above-mentioned method that involves (c) reshaping the organic material member by heating without changing the volume thereof, a method that involves softening or fusing (liquefying) the organic material member so as to change the shape thereof is given. However, other methods can be used.

Here, in the case that the electronic-component module is placed on the target board, which has solder paste printed thereon and is bonded to the target board with solder by reflow soldering, if a step of melting solder in the solder paste, which is printed on the surface of the target board, and a step of removing or reshaping the above-mentioned adsorption face member are performed in one operation as a step of reflow soldering, which is performed in a process of soldering the electronic-component module on the target board, a treatment to prevent the situation in which the upper end of the adsorption face member is higher than the upper ends of the surface-mount devices mounted on the electronic-component base plate can be performed without any additional step. This makes the present invention more advantageous. Note that, for mounting the electronic-component module, although a soldering method that involves reflow soldering is preferably used, another soldering method that involves flow-soldering can be also used.

Furthermore, if such a material that exists in a solid state until a step before reflow soldering, that is, until the last process in which the material is mounted and then vaporized, liquefied, softened, or reduced in volume at the soldering temperature during reflow soldering, is used, the adsorption face member is removed, reduced in volume, or reshaped in the reflow soldering step so as to prevent with certainty the situation in which the upper end of the adsorption face member is higher than the upper ends of the surface-mount devices mounted on the electronic-component base plate. This makes the present invention more advantageous.

Note that, when deformation or the like of the adsorption face member occurs during storage or transportation of the electronic-component module, adsorption using the adsorption head cannot be performed during mounting. Therefore, during the storage or transportation, the adsorption face member exists preferably in a solid state. That is, it is preferable that the adsorption face member exists stably in a solid state when the temperature is in the assurance range (generally from 50 to 80°C) of the electronic-component module.

Furthermore, if a member composed of naphthalene is used as the adsorption face member, for example, during reflow soldering in which the electronic-component module is bonded to the target board with solder, the adsorption face member can be removed or reduced in volume with ease and certainty, and the situation in which the upper end of the adsorption face member is higher than the upper ends of the surface-mount devices mounted on the electronic-component base plate can be prevented with certainty. This makes the present invention more advantageous.

Naphthalene is a material having a melting point of 81°C, a boiling point of 217°C, and sublimation properties. The melting point of naphthalene is higher than assurance temperatures of ordinary electronic-component modules and naphthalene is vaporized at the reflow temperature. Therefore, naphthalene can be preferably used as the adsorption face member.

Furthermore, in the case that a plurality of surface-mount devices are mounted on the electronic-component base plate and the adsorption face is formed at a position that is higher than the upper end of the tallest surface-mount device among the plurality of surface-mount devices, since any of the surface-mount devices among the plurality of surface-mount devices does not obstruct the operation of the adsorption head, the adsorption head can adsorb the adsorption face with certainty.

In the present invention, however, the position at which the adsorption face is formed is not limited to the position that is higher than that of the upper end of the tallest surface-mount device. The adsorption face can be formed at a position that is lower than that of the upper end of the tallest surface-mount device.

For example, in the case that the tallest surface-mount device is mounted on a part of a surface of the electronic-component base plate and other surface-mount devices, which are shorter than the tallest surface-mount device, are mounted on a main part of the surface thereof, if the adsorption face is formed at a position that is higher than that of the upper ends of the surface-mount devices mounted on the main part, the adsorption head can adsorb the adsorption face without any problems even though the position of the upper end of the tallest surface-mount device is higher than that of the adsorption face.

Therefore, by using the present invention, a height of the adsorption face member and an area, where the adsorption face member is formed, can be determined according to a given condition, that is, a face having surface-mount devices of the electronic-component module can be formed into any shape.

Furthermore, since the method for manufacturing an electronic apparatus of the present invention having a step of mounting an electronic-component module on a target board such as a motherboard involves the method for mounting an electronic-component module of the present invention, the electronic-component module can be adsorbed and held by the adsorption head with certainty, and then, the electronic-component module can be mounted on the target board. Therefore, electronic apparatuses with electronic-component modules can be efficiently manufactured, so that productivity can be improved and electronic apparatuses having economical advantages can be provided.

Furthermore, at a side of a face of the electronic-component module of the present invention having surface-mount devices thereon, the adsorption face, which is provided for being adsorbed with the adsorption head in adsorbing, is formed in a solid state at a position higher than that of upper ends of the surface-mount devices. The adsorption face has an adsorption face member which is vaporized, liquefied, softened, or reduced in volume at the melting temperature of the solder used in solder bonding. Therefore, by adsorbing the adsorption face of the adsorption face member with the adsorption head, the electronic-component module can be efficiently mounted using an automatic mounter and the like. Furthermore, for example, when the adsorption face member is mounted using the method of reflow soldering, the adsorption face member thereof can be removed, reduced in volume, or reshaped by reflow soldering with ease and certainty so as to efficiently prevent the situation in which the upper end of the adsorption face member is higher than the upper ends of surface-mount devices mounted on the electronic-component base plate.

Therefore, electronic-component modules that can be used in the mounting method of the present invention can be provided.

Furthermore, since a plurality of surface-mount devices are mounted on the electronic-component base plate and the adsorption face is formed at a position that is higher than the upper end of the tallest surface-mount device among the plurality of surface-mount devices, any of the surface-mount devices among the plurality of mounted surface-mount devices do not obstruct the operation of the adsorption head and the adsorption head can adsorb the adsorption face with certainty. This makes the present invention more advantageous.

### Brief Description of the Drawings

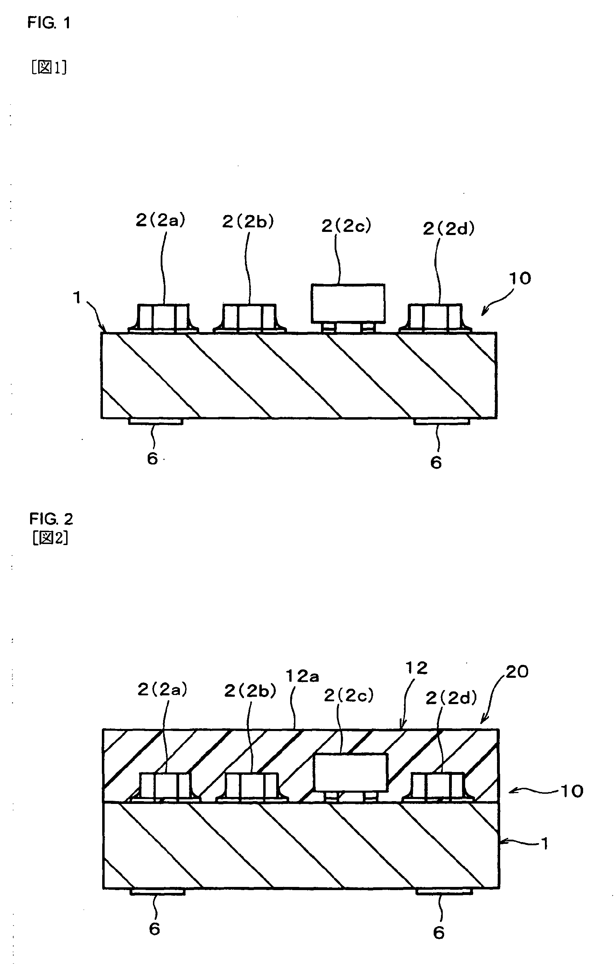

Fig. 1 is a view showing a structure of a main body of an electronic-component module in accordance with a first embodiment of the present invention;
Fig. 2 is a view showing a structure of the electronic-component module in accordance with the first embodiment of the present invention;

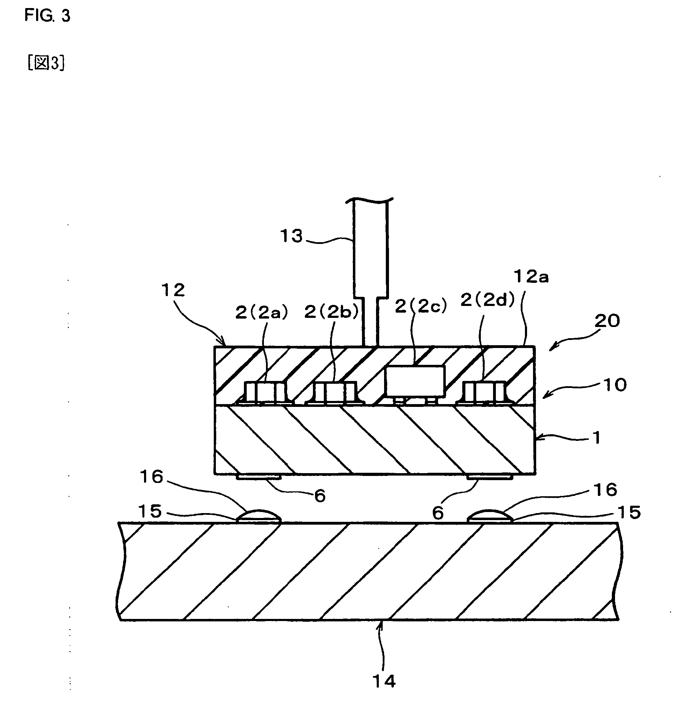

Fig. 3 is a view illustrating a method for mounting the electronic-component module in accordance with the first embodiment of the present invention on a motherboard serving as a target board by adsorbing and holding the electronic-component module using an adsorption head;

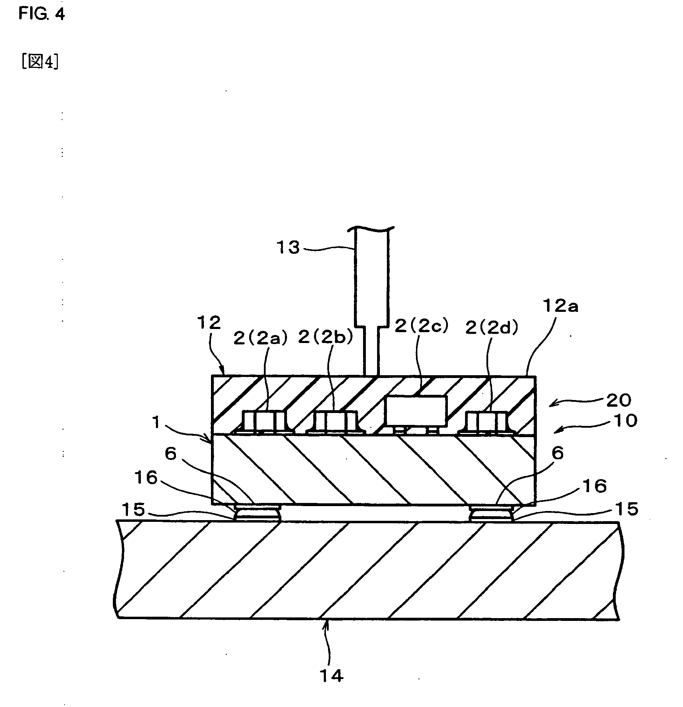

Fig. 4 is a view showing a state of the mounted electronic-component module in accordance with the first embodiment of the present invention on a motherboard serving as the target board by adsorbing and holding the electronic-component module using the adsorption head;

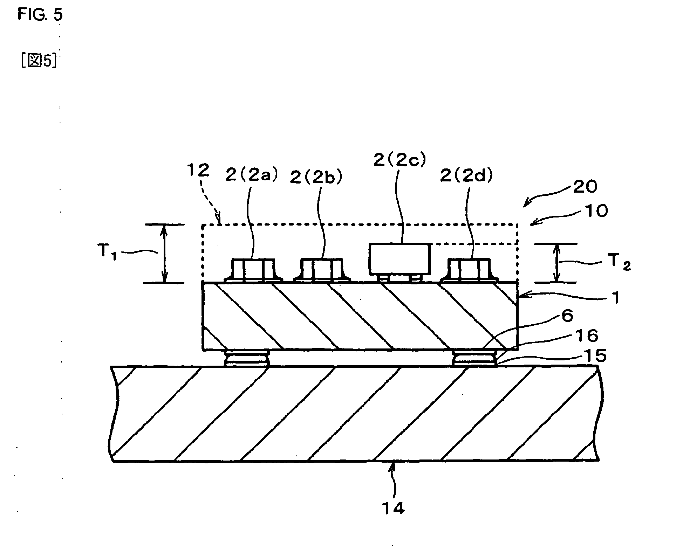

Fig. 5 is a view showing a state in which, after mounting the electronic-component module in accordance with the first embodiment of the present invention on the motherboard serving as the target board by adsorbing and holding the electronic-component module using the adsorption head, an adsorption face member is removed, which is performed as a problem solving treatment, to prevent a situation in which an upper end of the adsorption face member is higher than an upper end of the tallest surface-mount device mounted on the electronic-component base plate;

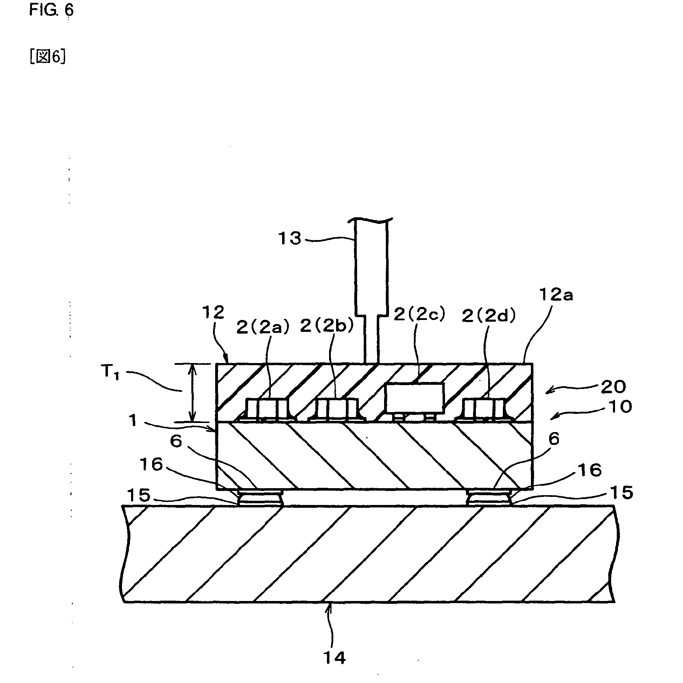

Fig. 6 is a view showing a structure of an electronic-component module in accordance with a second embodiment of the present invention and showing a state thereof that is placed on a motherboard serving as a target board;

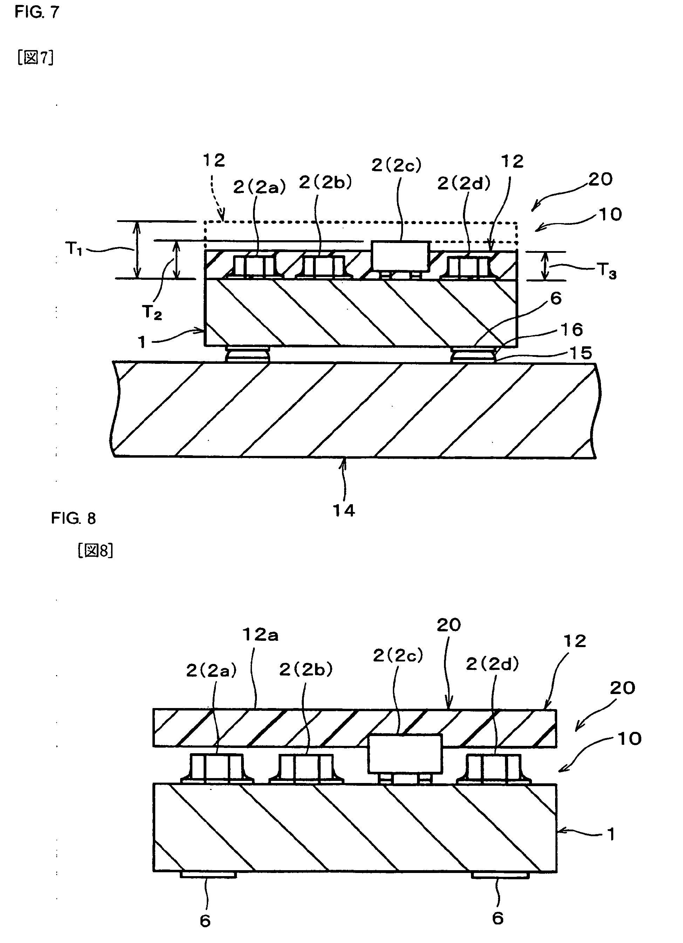

Fig. 7 is a view showing a state in which, after mounting the electronic-component module of the second embodiment of the present invention on a motherboard, the adsorption face member is reduced in volume, which is performed as a problem solving treatment, to prevent a situation in which an upper end of the adsorption face member is higher than an upper end of the tallest surface-mount device mounted on the electronic-component base plate;
Fig. 8 is a view showing a structure of an electronic-component module in accordance with a third embodiment of the present invention;

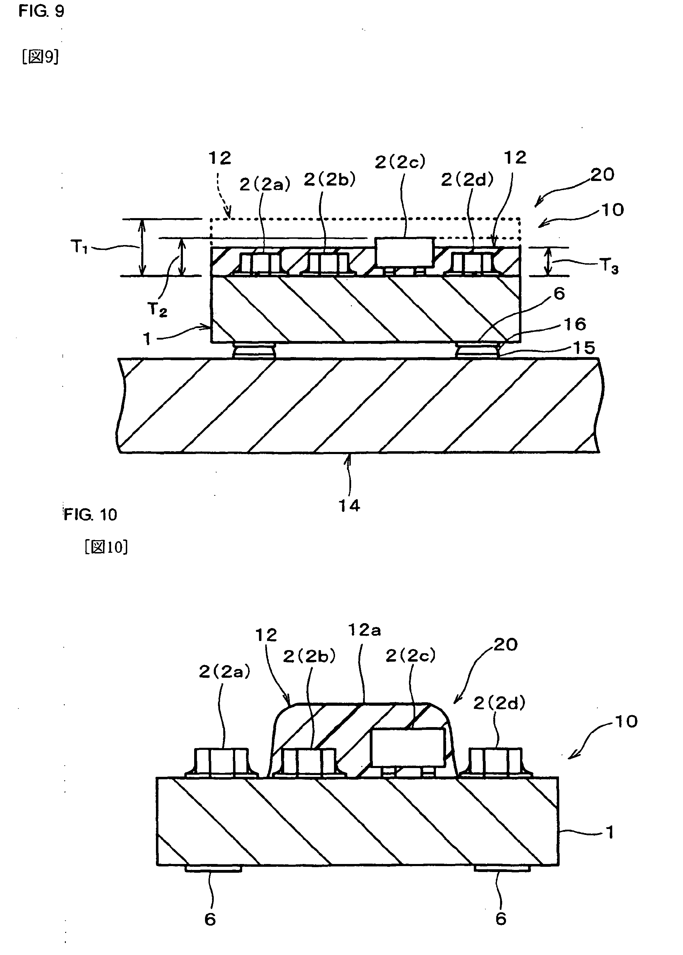

Fig. 9 is a view showing a state in which, after mounting the electronic-component module in accordance with the third embodiment of the present invention on the motherboard, the adsorption face member is reshaped, which is performed as a problem solving treatment, to prevent a situation in which an upper end of the adsorption face member is higher than an upper end of the tallest surface-mount device mounted on the electronic-component base plate;
Fig. 10 is a view showing an example of a modified electronic-component module in accordance with the third embodiment of the present invention;
Fig. 11 is a view showing an existing electronic-component module covered with a metal case that seals surface mount devices;
Fig. 12 is a view showing an electronic-component module covered with a molded resin instead of the metal case that seals surface-mount devices;
Fig. 13 is a view showing a method for mounting an existing electronic-component module on a motherboard and the like serving as a target board; and
Fig. 14 is another view showing a method for mounting an existing electronic-component module on a motherboard and the like serving as a target board.

### Reference Numerals

- 1: electronic-component base plate (ceramic board)
- 2: surface mount device
- 2a: capacitor
- 2b: resistor
- 2c: transistor
- 2d: coil
- 6: terminal electrode
- 10: main body of an electronic-component module
- 12a: adsorption face
- 12: adsorption face member
- 13: adsorption head
- 14: motherboard
- 15: land electrode
- 16: soldering paste
- 20: electronic-component module
- T₁: a height from an upper surface of an electronic-
- component: base plate
- T₂: a height that is substantially equal to the tallest surface mount device
- T₃: a height of an adsorption face member after reducing in volume or reshaping thereof

### Best Mode for Carrying Out the Invention

Examples of the present invention are described as follows and the properties of the present invention are described further in detail.

### First Embodiment

(1) As shown in Fig. 1, an electronic-component module main body 10 that has surface mount devices 2 (for example, capacitor 2a, resistor 2b, transistor 2c, coil 2d) mounted on an upper face of an electronic-component base plate 1 (ceramic board in this embodiment) having terminal electrodes 6 formed on a lower face thereof to be connected to a motherboard serving as a target board is prepared.
(2) Then, naphthalene (C₁₀H₈) which is an aromatic hydrocarbon is turned into a liquid state and poured onto a face of the electronic-component module main body 10 having the surface mount devices 2 mounted thereon. After being solidified, a surface, or an upper face of the solidified naphthalene shown in Fig. 2 is polished and flattened to form an adsorption face member 12 having an adsorption face 12a that is provided so as to be adsorbed with an adsorption head. In such a manner, as shown in Fig. 2, an electronic-component module 20 having a structure in which the adsorption face member 12 is provided to form the adsorption face 12a, which is adsorbed with an adsorption head 13 (refer to Fig. 3), at a position higher than that of an upper end of a transistor 2c, which is the tallest surface mounted device at a side of a face having the surface mount devices 2 (capacitor 2a, resistor 2b, transistor 2c, and coil 2d) mounted thereon is obtained. Note that, the naphthalene constituting the adsorption face member 12 of the electronic-component module 20 is a material selected as a material that exists in a solid state at about room temperature and at an assurance temperature for the electronic-component module (for example, 75°C) and is vaporized during reflow soldering at a soldering temperature mentioned below. The adsorption face member 12 is formed to be removable with certainty during reflow soldering.
(3) Next, as shown in Figs. 3 and 4, by adsorbing the adsorption face 12a, which is an upper face of the adsorption face member 12 of the electronic-component module 20, the adsorption head 13 holds the electronic-component module 20 and mounts the module 20 on a motherboard 14 serving as the target board. Previous to this step, soldering paste 16 is printed on land electrodes 15 of the motherboard 14.
(4) Then, the adsorption with the adsorption head 13 is ceased. After moving the adsorption head 13 upwards, the electronic-component module 20 with the motherboard 14 is carried into a reflow oven and heated at about 220°C for five minutes. Consequently, solder in the soldering paste 16 is melted and, as shown in Fig. 5, the terminal electrodes 6 on the electronic-component module 20 are bonded and fixed to the land electrodes 15 of the motherboard 14 and, at the same time, the adsorption face member 12 made of naphthalene is removed by vaporization.

As mentioned above, if the method for mounting an electronic-component module according to the first embodiment is used in mounting, by using the adsorption head 13 which adsorbs the adsorption face 12a of the adsorption face member 12, the electronic-component module 20 can be held with ease and certainty and can be efficiently mounted on the motherboard 14 with the adsorption head 13 of an automatic mounter or the like.

Furthermore, since the adsorption face member 12 is vaporized and removed with certainty in reflow soldering in a mounting process, T₁ (Fig. 5), which is the height measured from the upper surface of the electronic-component base plate 1 of the electronic-component module 20 having the adsorption face member 12 formed thereon, can be reduced to substantially the same height as the height T₂ of the transistor 2c which is the tallest surface-mount device. Therefore, a large reduction in the height of the electronic-component module can be achieved.

### Second Embodiment

Fig. 6 is a view showing a structure of an electronic-component module 20 in accordance with a second embodiment of the present invention and showing a state thereof that is placed on a motherboard. Fig. 7 is a view showing a state of the electronic-component module 20, which is shown in Fig. 6, after being mounted on a motherboard 14.

Note that, in Figs. 6 and 7, the same reference numerals as used in Figs. 1 to 5 denote the same portions as or portions corresponding to those shown in Figs. 1 to 5.

In the electronic-component module 20 in accordance with the second embodiment, an adsorption face member 12 thereof is reduced in volume during reflow soldering, so that an upper end thereof becomes lower than an upper end of the transistor 2c, which is the tallest surface-mount device mounted on an electronic-component base plate 1.

Note that, not a whole part of the adsorption face member 12 of the electronic-component module 20 in accordance with the second embodiment is removed in reflow soldering unlike the case in the first embodiment, that is, the adsorption face member 12 is reduced in volume, so that the upper end thereof becomes lower than the upper end of the transistor 2c, which is the tallest surface-mount device mounted on the electronic-component base plate 1. Except for this structure, the other structures, the manufacturing method, and the mounting method are same as described in the above-mentioned first embodiment.

Note that, in the second embodiment, naphthalene (C₁₀H₈) which is an aromatic hydrocarbon is used as the adsorption face member 12.

Naphthalene is a material that sublimates when heated. Therefore, if the heating temperature becomes high or the heating time becomes long, similar to the case in the above-mentioned first embodiment, the whole part thereof is vaporized to be eliminated. However, by controlling the temperature and time for heating, a part of the adsorption face member 12 can be removed, and the other part thereof can be left. This is a state in which the reduction thereof in volume occurred.

Note that as a material for the adsorption face member, which can be applied to the electronic-component module 20 in accordance with the second embodiment, that is, as a material that reduces in volume during a reflow soldering step, a resin that is shrinkable by polymerization reaction or the like, or a resin containing gaseous babbles that are released by deairing when heated resulting in a reduction in total volume can be used.

Furthermore, in the case that the electronic-component module 20 in accordance with the second embodiment is carried into a reflow oven with the motherboard 14 for example, by heating under conditions of lower temperature than that of the above-mentioned first embodiment, for example 200°C and five minutes, the volume of the adsorption face member can be reduced and the position of the upper face thereof can become lower than that of the tallest surface-mount device (transistor) 2c.

In the case of the electronic-component module 20 in accordance with the second embodiment, after reflow soldering, residue of the adsorption face member 12 has a thickness of T₃ (Fig. 7). Since the thickness T₃ is smaller than the height T₂ of the tallest surface-mount device (transistor) 2c, the height T₁ (Fig. 6) of the electronic-component module 20 measured from the upper face of the electronic-component base plate 1 in a situation in which the adsorption face member 12 is formed can be lowered, as shown in Fig. 7, to the height T₂ that is substantially the same height as the height of the transistor 2c of the tallest surface-mount device.

### Third Embodiment

Fig. 8 is a view showing a structure of an electronic-component module 20 in accordance with a third embodiment of the present invention. Fig. 9 is a view showing a state of the electronic-component module 20, which is shown in Fig. 8, after being mounted on the motherboard 14.

Note that, in Figs. 8 and 9, the same reference numerals as used in Figs. 1 to 5 denote the same portions as or portions corresponding to those shown in Figs. 1 to 5.

In the electronic-component module 20 in accordance with the third embodiment, the adsorption face member 12 thereof is made of a material that reshapes at reflow temperature, so that a position of the upper end of the adsorption face member 12 becomes lower than that of the transistor 2c, which is the tallest surface-mount device, and is provided over the upper face of the electronic-component base plate 1 in a floating state so that the upper face of the adsorption face member 12 can function as an adsorption face 12a for being adsorbed with the adsorption head.

Note that, for the material of the adsorption face member 12, a material which reshapes in reflow soldering and lowers the height of the upper end thereof is used. Except for the material, the structure of the electronic-component module 20 in accordance with the third embodiment, the manufacturing method, and the mounting method are same as described in the above-mentioned first embodiment.

Note that as the material used for the adsorption face member 12 in the electronic-component module 20 in accordance with the third embodiment, various materials those have higher melting points or softening points than the assurrance temperature thereof and lower than the reflow temperature, for example, β-naphthol (melting point, 123°C; boiling point, 285°C) can be used.

In the case of the electronic-component module 20 in accordance with the third embodiment, in reflow soldering, the adsorption face member 12 thereof reshapes to have a thickness of T₃ (Fig. 9). Since the thickness T₃ is smaller than the height T₂ of the tallest surface-mount device (transistor) 2c, the height T₁ of the electronic-component module 20 measured from the upper face of the electronic-component base plate 1 in a situation in which the adsorption face member 12 is formed can be lowered, as shown in Fig. 9, to the height T₂ that is substantially the same height as the height of the transistor 2c of the tallest surface-mount device.

Note that the electronic-component module having the adsorption face member 12 made of a material that reshapes at a reflow temperature, so that a position of the upper end thereof becomes lower than that of the transistor 2c, which is the tallest surface-mount device, is not limited to the module having a structure shown in the above-mentioned Fig. 8. As shown in Fig. 10, a structure in which the adsorption face member 12 is formed in a convex shape at the center portion of the electronic-component base plate 1 so that the upper face of the adsorption face member 12 being higher than the transistor 2c, which is the tallest surface-mount device, serves as the adsorption face 12a can be used.

In the case of the structure shown in Fig. 10, in reflow soldering, the adsorption face member 12 thereof reshapes as shown in Fig. 9. Since the position of the upper end thereof becomes lower than the height T₂ of the tallest surface-mount device, transistor 2c, the height T₁ of the electronic-component module 20 measured from the upper face of the electronic-component base plate 1 in a situation in which the adsorption face member 12 is formed can be lowered, as shown in Fig. 9, to the height T₂ that is substantially the same height as the height of the transistor 2c of the tallest surface-mount device.

Note that the scope of the present invention is not limited to the above-mentioned embodiments. Within the scope of the invention, various applications and modifications can be made on the condition to prevent the situation in which the upper end of the adsorption face member is higher than the upper ends of the surface-mount devices, and the like, by changing the specific shape structure of the adsorption face member, the method for forming an adsorption face member, a structure of electronic-component base plate constituting the electronic-component module, the type of surface-mount devices mounted on the electronic-component base plate, and by removing or reshaping the adsorption face member.

### Industrial Applicability

As mentioned above, according to the present invention, in a mounting step, by using an adsorption head to adsorb an adsorption face of an adsorption face member, an electronic-component module can be held with ease and certainty and can be efficiently mounted with an automatic mounter. After the mounting step, since the situation in which the upper end of the adsorption face member is higher than the upper ends of the surface-mount devices mounted on the electronic-component base plate is prevented with certainty, the maximum reduction of a height of a resulting product can be achieved.

Furthermore, if a treatment to prevent the situation in which the upper end of the adsorption face member is higher than the upper ends of the surface-mount devices mounted on the electronic-component base plate and reflow soldering, which is performed in a process of soldering the electronic-component module on the target board, are performed in one operation, the above-mentioned treatment can be performed without any additional steps.

Furthermore, by applying the method for mounting an electronic-component module of the present invention, electronic apparatuses provided with electronic-component modules can be efficiently manufactured, so that productivity can be improved.

Therefore, the present invention can be widely applied to various technical fields involving steps of mounting electronic-component modules, particularly to a field of manufacturing electronic apparatuses provided with electronic-component modules therein.

## Claims

1. A method for mounting an electronic-component module (20) composed of an electronic-component base plate (1) and a surface-mount device (2) mounted on the face thereof comprising the steps of:
providing an adsorption face member (12) in such a manner that an adsorption face (12a) that is provided so as to be adsorbed with an adsorption head (13) in adsorbing is formed on the face of the electronic-component module (20) at a position higher than that of an upper end of the surface-mount device (2);
holding the electronic-component module (20) by adsorbing the adsorption face (12a) with the adsorption head, and mounting the electronic-component module (20) on a target board (14); and
after mounting the electronic-component module (20) on the target board (14), removing or reshaping the adsorption face member (12) to prevent a situation in which an upper end of the adsorption face member (12) is higher than the upper end of the surface-mount device (2) mounted on the electronic-component base plate (1),
**characterized in that** the adsorption face member (12) is an organic material member and the step of removing or reshaping the adsorption face member (12) is composed of at least one of the steps described below,
(a) eliminating the organic material member by heating
(b) reducing the organic material member in volume by heating
(c) reshaping the organic material member by heating without changing the volume thereof.

2. The method for mounting the electronic-component module (20) according to claim 1,
wherein the electronic-component module (20) is mounted on the target board (14) having solder paste (16) printed thereon and is bonded to the target board (14) by reflow soldering, and a step of melting solder in the solder paste (16) printed on a surface of the target board (14) and a step of removing or reshaping the above-mentioned adsorption face member (12) are performed in one operation as a step of reflow soldering performed in a process of soldering the electronic-component module (20) on the target board (14).

3. The method for mounting the electronic-component module (20) according to claim 2,
wherein the adsorption face member (12) exists in a solid state previous to the reflow soldering step, and is vaporized, liquefied, softened, or reduced in volume at the soldering temperature during the reflow soldering step.

4. The method for mounting the electronic-component module (20) according to any one of claims 1 to 3, wherein the adsorption face member (12) is made of naphthalene.

5. The method for mounting the electronic-component module (20) according to any one of claims 1 to 4,
wherein a plurality of the surface-mount devices (2) are mounted on the electronic-component base plate (1) and the adsorption face (12a) is formed at a position higher than that of an upper end of the tallest surface-mount device (2) among the plurality of surface-mount devices (2).

6. A method for manufacturing an electronic apparatus having an electronic-component module (20) on a target board (14), the method comprising a step of mounting the electronic-component module (20) on the target board (14) by the method according to any one of claims 1 to 5.

7. An electronic-component module (20) comprising:
an electronic-component base plate (1) and a surface-mount device (2) mounted on the electronic-component base plate (1),
wherein, at a side of a face of the electronic-component module (20) having the surface-mount device (2) mounted thereon, an adsorption face member (12) configured to form an adsorption face (12a) that may be adsorbed with an adsorption head (13), the adsorption face member (12) being in a solid state and the adsorption face (12a) being at a position that is higher than that of an upper end of the surface-mount device (2), **characterised in that** the adsorption face member (12) is vaporized or reduced in volume at melting temperature of solder (16) used in solder bonding.

8. The electronic-component module (20) according to claim 7,
wherein a plurality of the surface-mount devices (2) are mounted on the electronic-component base plate (1) and the adsorption face (12a) is formed at a position higher than that of an upper end of the tallest surface-mount device (2) among the plurality of surface-mount devices (2).

## Patentansprüche

1. Ein Verfahren zum Befestigen eines Elektronikkomponentenmoduls (20), das aus einer Elektronikkomponentenbasisplatte (1) und einem Oberflächenbefestigungsbauelement (2) besteht, das auf der Fläche befestigt ist, das folgende Schritte aufweist:
Bereitstellen eines Adsorptionsflächenbauglieds (12) auf solche Weise, dass eine Adsorptionsfläche (12a), die derart vorgesehen ist, um mit einem Adsorptionskopf (13) beim Adsorbieren adsorbiert zu werden, auf der Fläche des Elektronikkomponentenmoduls an einer Position gebildet ist, die höher ist als die eines oberen Endes des Oberflächenbefestigungsbauelements (2);
Halten des Elektronikkomponentenmoduls (20) durch Adsorbieren der Adsorptionsfläche (12a) mit dem Adsorptionskopf und Befestigen des Elektronikkomponentenmoduls (20) an einer Zielplatine (14); und
nach dem Befestigen des Elektronikkomponentenmoduls (20) an der Zielplatine (14), Entfernen oder Neuformen des Adsorptionsflächenbauglieds (12), um eine Situation zu verhindern, in der ein oberes Ende des Adsorptionsflächenbauglieds (12) höher ist als das obere Ende des Oberflächenbefestigungsbauelements (2), das auf der Elektronikkomponentenbasisplatte (1) befestigt ist,
**dadurch gekennzeichnet, dass** das Adsorptionsflächenbauglied (12) ein Bauglied aus organischem Material ist und der Schritt zum Beseitigen oder Neuformen des Adsorptionsflächenbauglieds (12) aus zumindest einem der nachfolgend beschriebenen Schritte besteht,
(a) Beseitigen des Bauglieds aus organischem Material durch Erwärmen
(b) Reduzieren des Bauglieds aus organischem Material in seinem Volumen durch Erwärmen
(c) Neuformen des Bauglieds aus organischem Material durch Erwärmen ohne das Volumen desselben zu verändern.

2. Das Verfahren zum Befestigen eines Elektronikkomponentenmoduls (20) gemäß Anspruch 1,
bei dem das Elektronikkomponentenmodul (20) auf der Zielplatine (14) befestigt ist, mit einer Lötmittelpaste (16), die darauf gedruckt ist, und mit der Zielplatine (14) verbunden ist durch Rückflusslöten, und ein Schritt zum Schmelzen von Lötmittel in der Lötmittelpaste (16), die auf eine Oberfläche der Zielplatine (14) gedruckt ist, und ein Schritt zum Entfernen und Neuformen des oben erwähnten Adsorptionsflächenbauglieds (12) in einer Operation ausgeführt werden als ein Schritt eines Rückflusslötens, der in einem Prozess des Lötens des Elektronikkomponentenmoduls (20) auf der Zielplatine (14) ausgeführt wird.

3. Das Verfahren zum Befestigen des Elektronikkomponentenmoduls (20) gemäß Anspruch 2,
bei dem das Adsorptionsflächenbauglied (12) in einem festen Zustand vor dem Rückflusslötschritt vorliegt und während des Rückflusslötschrittes bei der Löttemperatur verdampft, verflüssigt, erweicht oder im Volumen reduziert wird.

4. Das Verfahren zum Befestigen eines Elektronikkomponentenmoduls (20) gemäß einem der Ansprüche 1 bis 3, bei dem das Adsorptionsflächenbauglied (12) aus Naphthalen hergestellt ist.

5. Das Verfahren zum Befestigen eines Elektronikkomponentenmoduls (20) gemäß einem der Ansprüche 1 bis 4,
bei dem eine Mehrzahl der Oberflächenbefestigungsbauelemente (2) auf der Elektronikkomponentenbasisplatte (1) befestigt ist und die Adsorptionsfläche (12a) an einer höheren Position gebildet ist als der eines oberen Endes des größten Oberflächenbefestigungsbauelements (2) aus der Mehrzahl von Oberflächenbefestigungsbauelementen (2).

6. Ein Verfahren zum Herstellen einer elektronischen Vorrichtung mit einem Elektronikkomponentenmodul (20) auf einer Zielplatine (14), wobei das Verfahren einen Schritt aufweist zum Befestigen des Elektronikkomponentenmoduls (20) auf der Zielplatine (14) durch das Verfahren gemäß einem der Ansprüche 1 bis 5.

7. Ein Elektronikkomponentenmodul (20), das folgende Merkmale aufweist:
eine Elektronikkomponentenbasisplatte (1) und ein Oberflächenbefestigungsbauelement (2), das auf der Elektronikkomponentenbasisplatte (1) befestigt ist,
wobei an einer Seite einer Fläche des Elektronikkomponentenmoduls (20), das das Oberflächenbefestigungsbauelement (2) aufweist, das daran befestigt ist, ein Adsorptionsflächenbauglied (12) konfiguriert ist, um eine Adsorptionsfläche (12a) zu bilden, die mit einem Adsorptionskopf (13) adsorbiert werden kann, wobei das Adsorptionsflächenbauglied (12) in einem festen Zustand ist und die Adsorptionsfläche (12a) an einer Position ist, die höher ist als die eines oberen Endes des Oberflächenbefestigungsbauelements (2), **dadurch gekennzeichnet, dass** das Adsorptionsflächenbauglied (12) bei Schmelztemperatur des Lötmittels (16), das zum Lötmittelverbinden verwendet wird, verdampft oder im Volumen reduziert wird.

8. Das Elektronikkomponentenmodul (20) gemäß Anspruch 7,
bei dem eine Mehrzahl der Oberflächenbefestigungsbauelemente (2) auf der Elektronikkomponentenbasisplatte (1) befestigt ist und die Adsorptionsfläche (12a) an einer höheren Position gebildet ist als der eines oberen Endes des größten Oberflächenbefestigungsbauelements (2) aus der Mehrzahl von Oberflächenbefestigungsbauelementen (2).

## Revendications

1. Procédé de montage d'un module de composants électroniques (20) composé d'une plaque de base de composants électroniques (1) et d'un dispositif monté en surface (2) monté sur la face de celui-ci, comprenant les étapes consistant à :
fournir un élément de face d'adsorption (12) de manière à ce qu'une face d'adsorption (12a) qui est prévue de manière à être adsorbée par une tête d'adsorption (13) lors d'une adsorption soit formée sur la face du module de composants électroniques (20) à une position supérieure à celle d'une extrémité supérieure du dispositif monté en surface (2) ;
maintenir le module de composants électroniques (20) en adsorbant la face d'adsorption (12a) avec la tête d'adsorption, et monter le module de composants électroniques (20) sur une carte cible (14) ; et
après le montage du module de composants électroniques (20) sur la carte cible (14), retirer ou remettre en forme l'élément de face d'adsorption (12) pour éviter une situation dans laquelle une extrémité supérieure de l'élément de face d'adsorption (12) est située plus haut que l'extrémité supérieure du dispositif monté en surface (2) monté sur la plaque de base de composants électroniques (1),
**caractérisé en ce que** l'élément de face d'adsorption (12) est un élément de matériau organique et l'étape de retrait ou de remise en forme de l'élément de face d'adsorption (12) est composée d'au moins l'une des étapes décrites ci-dessous consistant à :
(a) éliminer l'élément de matériau organique par chauffage ;
(b) réduire l'élément de matériau organique en volume par chauffage ;
(c) remettre en forme l'élément de matériau organique par chauffage sans modifier le volume de celui-ci.

2. Procédé de montage du module de composants électroniques (20) selon la revendication 1,
dans lequel le module de composants électroniques (20) est monté sur la carte cible (14) sur laquelle une pâte de soudure (16) est imprimée et est lié à la carte cible (14) par soudage par refusion, et une étape de fusion de soudure dans la pâte de soudure (16) imprimée sur une surface de la carte cible (14) et une étape de retrait ou de remise en forme de l'élément de face d'adsorption (12) mentionné ci-dessus sont effectuées en une opération en tant qu'étape de soudage par refusion effectuée dans un processus de soudage du module de composants électroniques (20) sur la carte cible (14).

3. Procédé de montage du module de composants électroniques (20) selon la revendication 2,
dans lequel l'élément de face d'adsorption (12) existe dans un état solide avant l'étape de soudage par refusion, et est vaporisé, liquéfié, ramolli ou réduit en volume à la température de soudage pendant l'étape de soudage par refusion.

4. Procédé de montage du module de composants électroniques (20) selon l'une quelconque des revendications 1 à 3, dans lequel l'élément de face d'adsorption (12) est réalisé en naphtalène.

5. Procédé de montage du module de composants électroniques (20) selon l'une quelconque des revendications 1 à 4,
dans lequel une pluralité des dispositifs montés en surface (2) sont montés sur la plaque de base de composants électroniques (1) et la face d'adsorption (12a) est formée à une position supérieure à celle d'une extrémité supérieure du dispositif monté en surface (2) le plus haut parmi la pluralité de dispositifs montés en surface (2).

6. Procédé de fabrication d'un dispositif électronique comportant un module de composants électroniques (20) sur une carte cible (14), le procédé comprenant une étape de montage du module de composants électroniques (20) sur la carte cible (14) par le procédé selon l'une quelconque des revendications 1 à 5.

7. Module de composants électroniques (20) comprenant :
une plaque de base de composants électroniques (1) et un dispositif monté en surface (2) monté sur la plaque de base de composants électroniques (1),
dans lequel, d'un côté d'une face du module de composants électroniques (20) sur laquelle le dispositif monté en surface (2) est monté, un élément de face d'adsorption (12) est configuré pour former une face d'adsorption (12a) qui peut être adsorbée par une tête d'adsorption (13), l'élément de face d'adsorption (12) étant dans un état solide et la face d'adsorption (12a) étant à une position qui est supérieure à celle d'une extrémité supérieure du dispositif monté en surface (2), **caractérisé en ce que** l'élément de face d'adsorption (12) est vaporisé ou réduit en volume à la température de fusion de la soudure (16) utilisée dans la liaison par soudure.

8. Module de composants électroniques (20) selon la revendication 7,
dans lequel une pluralité des dispositifs montés en surface (2) sont montés sur la plaque de base de composants électroniques (1) et la face d'adsorption (12a) est formée à une position supérieure à celle d'une extrémité supérieure du dispositif monté en surface (2) le plus haut parmi la pluralité de dispositifs montés en surface (2).
